# DEMANDE DE BREVET EUROPEEN

(11) **EP 2 159 849 A2**
(43) Date de publication de la demande: **03.03.2010**
(21) Numéro de dépôt: 09167875.5
(22) Date de dépôt: 14.08.2009
(51) Int. Cl.: H01L 31/045

(54) **Composite enroulable photovoltaïque et dispositif de protection solaire comportant un tel composite**

(30) Priorité: 29.08.2008 FR 0855829
(71) Demandeur: Dickson Constant, 59290 Wasquehal (FR)
(72) Inventeur: Nocito, Christosphe, 59100, ROUBAIX (FR); Koncar, Vladan, 59320, HAUBOURDIN (FR); Raymond, Laurent, 59134, FOURNES EN WEPPES (FR)
(74) Mandataire: Cochonneau, Olivier

(57) **Abrégé**

La présente invention a pour objet un composite (1) enroulable photovoltaïque, notamment pour la protection solaire, comprenant au moins un panneau photovoltaïque souple (4) et au moins un panneau textile (2) sur la face extérieure (2a) duquel est laminé ledit panneau photovoltaïque à l'aide d'une première couche de liaison (13) **caractérisé en ce que**, dans la direction transversale (F) à celle prévue pour son enroulement et à tout niveau (9) du panneau photovoltaïque (4), il présente une épaisseur (E) sensiblement constante, ne comportant qu'une ou plusieurs zones (11,12) d'épaisseur réduite (E₀), ladite épaisseur correspondant à l'épaisseur du panneau textile (2) éventuellement revêtu d'une enduction sur sa face intérieure, dont la largeur ℓ est au plus de 8 centimètres, en sorte d'éviter la formation de plis lors de l'enroulement ou en position déployée.

## Description

La présente invention concerne le domaine des composites enroulables photovoltaïques, notamment pour panneau ou store de protection solaire, comprenant au moins une cellule photovoltaïque.

Une cellule photovoltaïque est un générateur appelée aussi photopile qui utilise l'effet photovoltaïque. L'effet photovoltaïque peut être défini comme étant l'apparition d'une différence de potentiel entre deux couches d'une plaquette de semi-conducteur dont les conductivités sont opposées, ou entre un semi-conducteur et un métal, sous l'effet d'un flux lumineux. Une cellule photovoltaïque génère un courant continu.

Un semi-conducteur est généralement un matériau solide dont la résistivité, intermédiaire entre celle des métaux et celle des isolants, varie sous l'influence des facteurs telle que la température, l'éclairement, le champ électrique,...etc.

Les principaux matériaux semi-conducteurs connus sont le germanium, le silicium et le sélénium.

On connaît un chargeur solaire portatif décrit dans WO 2004/077577. Ce chargeur comprend un panneau photovoltaïque souple qui est fixé de façon permanente sur un textile souple. Ledit panneau solaire ou photovoltaïque peut être cousu selon ses bords inactifs à la feuille textile flexible, ou collé, ou encore soudé par apport de chaleur ou d'ultrasons.

La fabrication de ce type de chargeur solaire est encore aujourd'hui artisanale. Il n'existe pas de techniques à ce jour permettant de fabriquer des ensembles, résultant de l'assemblage d'une feuille textile et d'un ou plusieurs panneaux souples photovoltaïques, de grandes dimensions de façon industrielle.

Ces chargeurs de petites dimensions présentent une surface de collecte des rayons incidents faible. De plus, lorsqu'ils sont agencés pour former des panneaux de protection solaire, par exemple pour constituer un store, les coffres de rangement doivent être redimensionnés ne serait ce que pour recevoir la feuille textile à l'état enroulé dont l'épaisseur a très sensiblement augmenté voire doublé une fois assemblée avec un ou plusieurs panneaux photovoltaïques.

De plus, on remarque la formation de plis rédhibitoires lors de l'utilisation, plis qui peuvent éventuellement gêner l'enroulement et son introduction dans le coffre de rangement ou encore qui altère l'esthétique du composite lorsqu'il est en position déployée.

On utilise, dans le présent texte, le terme extérieur pour désigner ce qui est destiné à être tourné vers le rayonnement solaire, lors de l'utilisation finale, et bien sûr inversement pour le terme intérieur.

La présente invention pallie les problèmes techniques précités. Elle a pour objet, selon un premier aspect, un composite enroulable photovoltaïque, notamment pour la protection solaire, comprenant au moins un panneau photovoltaïque souple et au moins un panneau textile sur la face extérieure duquel est laminé ledit panneau photovoltaïque à l'aide d'une première couche de liaison. De manière caractéristique, dans la direction transversale à celle prévue pour son enroulement et à tout niveau du panneau photovoltaïque, ledit composite présente une épaisseur sensiblement constante, ne comportant qu'une ou plusieurs zones d'épaisseur réduite, ladite épaisseur réduite correspondant à l'épaisseur du panneau textile éventuellement revêtu d'une enduction sur sa face intérieure, chaque zone d'épaisseur réduite ayant une largeur qui est au plus de 8 centimètres. Cette disposition particulière permet d'éviter la formation de plis sur le composite, que ce soit lors de l'enroulement ou en position déployée.

Le demandeur a en effet, à l'occasion des essais réalisés, pu constater qu'en réduisant la largeur des zones longitudinales d'épaisseur réduite, dans la partie du composite qui comporte au moins un panneau photovoltaïque, il était possible de limiter voire éliminer totalement la formation de plis, pour autant que la largeur de chaque zone soit au plus de 8 centimètres. Bien sûr, la largeur adéquate qui est à retenir peut dépendre de différents paramètres, notamment la contexture du panneau textile, son épaisseur, et la tension qui est appliquée sur le composite lors de son utilisation et son enroulement.

Chaque panneau photovoltaïque est, dans le présent texte, un ensemble qui comprend au moins une cellule photovoltaïque recouverte par une couche de protection, laquelle est dans un matériau laissant passer le rayonnement lumineux, par exemple un polytétrafluoréthylène transparent du type ETFE, ladite couche de protection étant laminée sur la cellule à l'aide d'une seconde couche de liaison. Dans ce cas, avantageusement selon la présente invention, la première et la seconde couche de liaison et la couche de protection ont les mêmes dimensions, lesquelles sont supérieures à celles de la cellule photovoltaïque.

Cette disposition particulière présente au moins deux avantages. D'abord, elle permet d'assurer une protection efficace de la cellule photovoltaïque, celle-ci étant totalement incluse dans les différentes couches de liaison et de protection, ce qui limite les risques de dégradation. D'autre part, elle permet, pour une largeur donnée de cellule photovoltaïque d'augmenter relativement la largeur de la zone d'épaisseur importante et corrélativement de réduire la largeur de la ou des zones d'épaisseur réduite. Il est à noter que la cellule photovoltaïque en tant que telle a une épaisseur relativement faible puisqu'il s'agit généralement d'un film sur lequel est effectué un dépôt de semi-conducteur, notamment de silicium, l'ensemble ayant une épaisseur de l'ordre de 50 µm. Comparativement, les couches de liaison peuvent faire de l'ordre de 200 à 500 µm et la couche de protection de l'ordre de 50 µm. Ainsi, selon sa largeur, le panneau photovoltaïque a, dans ce cas, une épaisseur qui reste sensiblement constante, même selon les deux parties latérales exemptes de cellules photovoltaïques.

Avantageusement, le panneau textile comporte selon ses bords longitudinaux un ourlet de finition formé d'un repli cousu. Le composite a donc, sur toute la largeur d'un tel ourlet, une épaisseur qui est sensiblement le double de celle du panneau textile. Il est donc ainsi possible, si nécessaire, de diminuer la largeur de la ou des zones d'épaisseur réduite en augmentant la largeur de cet ourlet de finition.

Dans une variante de réalisation, le composite comporte au moins deux panneaux textiles assemblés deux à deux par superposition et assemblage, notamment par collage à chaud, d'une portion s'étendant le long des bords longitudinaux adjacents des deux panneaux ; de plus sur chaque panneau textile est laminée au moins une cellule photovoltaïque ; enfin le bord longitudinal du panneau textile venant au dessus de l'autre panneau dans l'assemblage est, dans ce cas, a une distance d du panneau photovoltaïque supporté par cet autre panneau textile ; selon l'invention, la valeur de cette distance d est au plus égale à 8 centimètres.

Certes, la solution optimale consisterait à ce qu'il n'y ait qu'un jeu très faible, de quelques millimètres, entre le panneau photovoltaïque et le bord longitudinal en question. Cependant, ceci n'est guère envisageable compte tenu des contraintes liées à la technologie d'assemblage actuelle.

Dans tous les cas, quel que soit l'emplacement de la zone d'épaisseur réduite, il importe que sa largeur soit la plus faible possible pour limiter voire éliminer totalement la formation de plis lors de l'enroulement du composite ou lorsque celui-ci est en extension en position déployée.

Selon la structure du composite, notamment la contexture et l'épaisseur du panneau textile, la largeur de la ou des zones d'épaisseur réduite peut varier pour obtenir le résultat optimal. Si des résultats acceptables ont été obtenus avec des largeurs proches de 8 centimètres, les meilleurs résultats ont été obtenus avec des largeurs au plus égales à 4 centimètres, sachant qu'une largeur de l'ordre de 2 centimètres permet d'obtenir une absence de plis dans tous les cas de figure.

De préférence, la face intérieure du panneau textile est revêtue d'une enduction dont l'un des buts est d'empêcher le transpercement dudit panneau lors du laminage à chaud de la première couche de liaison entre la cellule photovoltaïque et le panneau textile. Cette enduction sert donc de barrière à la diffusion du matériau ramolli de la couche de liaison lors du laminage. La présence de cette enduction pose un problème lorsque les panneaux textiles sont assemblés deux par deux par superposition et assemblage par collage à chaud, du fait que le collage contre la face enduite est alors de médiocre qualité, provoquant d'éventuels délaminages des panneaux. Pour remédier à ce problème, les faces intérieures des panneaux textiles assemblés sont revêtues de l'enduction en question, exception faite de la portion, dite de réserve, du panneau textile venant au dessus de l'autre dans l'assemblage ; ainsi le collage se fait entre deux faces qui sont toutes deux exemptes d'enduction.

Selon une variante de réalisation, le composite comporte une partie avant qui est exempte de panneau photovoltaïque. On désigne par partie avant, la partie du composite dont le bord transversal est destiné à être fixé à un tube de réception pour son enroulement. Cette partie avant exempte de panneau photovoltaïque est utilisée en premier lieu pour la fixation du composite au tube de réception. On comprend que lors de l'enroulement du composite, c'est la partie avant qui va d'abord s'enrouler autour du tube de réception suivie de la partie arrière comprenant le ou les panneaux photovoltaïques. Certes, les cellules photovoltaïques sont suffisamment souples pour être enroulées, mais avec un enroulement selon un rayon de courbure minimale, faute de quoi il y aurait un risque de dégradation de la cellule. Ainsi, en second lieu, cette disposition particulière permet, pour une cellule photovoltaïque ayant un rayon de courbure minimale donné, de diminuer le rayon de courbure du tube de réception.

Dans un mode préférentiel de réalisation, la partie avant du composite, exempte de panneau photovoltaïque, a une longueur La qui fait au moins le quart de la longueur totale Lt dudit composite. Dans ce cas, le tube de réception peut avoir un rayon extérieur qui est inférieur ou égal à 2 centimètres.

La présente invention sera mieux comprise à la lecture de la description qui va être faite d'un exemple de réalisation cité à titre non limitatif, et illustré par les figures ci-après annexées à la présente et dans lesquelles :
- la figure 1 est une vue de dessus d'un composite photovoltaïque enroulable comportant deux panneaux textiles assemblés et, sur chaque panneau textile un panneau photovoltaïque comportant trois cellules ;
- la figure 2 est une vue partielle selon le plan de coupe II-II du composite de la figure 1 ;
- la figure 3 est une vue en perspective d'un dispositif de protection solaire pour un camping-car comprenant un composite photovoltaïque.

Le composite enroulable photovoltaïque qui va être décrit ci-dessous et illustré aux figures est destiné à former un store de protection solaire pour camping-car. Cette description et cette application ne sont bien sûr pas limitatives de la présente invention.

Dans sa composition la plus simple, le composite de la présente invention comprend un seul panneau textile sur la face extérieure duquel est fixée une seule cellule photovoltaïque, cette fixation intervenant par laminage à chaud d'une couche de liaison formée à partir d'un polymère thermofusible, de préférence dans un polymère à base d'EVA (copolymère d'éthylène et d'acétate de vinyle). Cette cellule photovoltaïque est revêtue d'une couche de protection dans un matériau qui est transparent au rayonnement solaire, non conducteur d'électricité et résistant à l'abrasion. Il peut s'agir par exemple d'un polytétrafluoréthylène transparent du type ETFE. Etant donné qu'une telle couche de protection n'est pas par elle-même adhérente, sa fixation nécessite la mise en oeuvre d'une seconde couche de liaison pour sa fixation sur la cellule photovoltaïque. Cette seconde couche de liaison peut être dans le même matériau que la couche de liaison qui est utilisée pour fixer la cellule photovoltaïque sur le panneau textile, par exemple en EVA.

L'ensemble constitué par la couche de protection, la seconde couche de liaison et la cellule photovoltaïque constitue un panneau photovoltaïque. Dans le présent texte, le terme panneau photovoltaïque est également utilisé dans le cas où il y a plusieurs cellules.

Bien sûr, le nombre de panneaux textiles et de cellules photovoltaïques va dépendre de l'application concernée et donc des dimensions en longueur et en largeur qui sont souhaitées ainsi que la surface des cellules photovoltaïques nécessaires pour cette application.

Dans l'exemple illustré, le composite 1 comporte deux panneaux textiles 2,3, chacun étant laminé avec un panneau photovoltaïque 4,5 qui comprend lui-même trois cellules photovoltaïques 6,7,8.

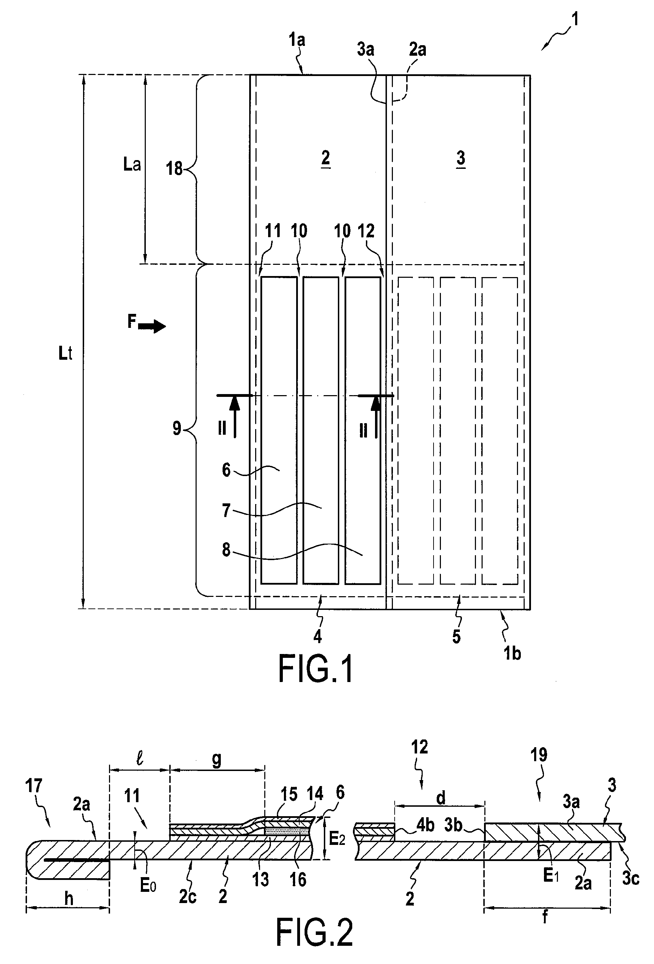

De manière caractéristique, selon la présente invention, l'agencement des différents éléments entrant dans la structure et la confection du composite 1 est tel que celui-ci présente une épaisseur E₂ qui est sensiblement constante lorsqu'on examine cette épaisseur selon la direction transversale symbolisée par la flèche F sur la figure 1, direction qui est perpendiculaire à celle qui est prévue pour l'enroulement du composite et ce, sur toute la longueur 9 du panneau photovoltaïque 4,5, ledit composite 1 ne comportant qu'une seule ou plusieurs zones 11,12 d'épaisseur réduite E₀. On désigne sous le terme d'épaisseur réduite E₀, une épaisseur qui correspond à l'épaisseur du panneau textile 2,3 éventuellement revêtu d'une enduction sur sa face intérieure 2c. De plus, la largeur ℓ de la ou de chaque zone d'épaisseur réduite E₀ est au plus de 8 centimètres. Ainsi, selon le demandeur, il est possible de limiter voire d'éviter les risques de formation de plis sur le composite lors de l'enroulement de celui-ci ou lorsqu'il est en position déployée.

C'est après avoir procédé à de multiples essais que le demandeur a pu constater qu'il convenait de réduire autant que faire ce peut la largeur des zones d'épaisseur réduite, c'est-à-dire des bandes longitudinales dans lesquelles le panneau textile seul, incluant éventuellement son enduction, s'étend sur toute la longueur de la partie arrière 9 qui comporte les cellules photovoltaïques 6,7,8.

En l'occurrence, s'agissant de l'exemple de réalisation de la figure 1, sur la partie arrière 9 en question du panneau textile 2, il y a deux bandes longitudinales centrales 10, une bande latérale gauche 11 et une bande latérale droite 12.

Les deux bandes centrales 10 correspondent aux zones qui s'étendent entre deux cellules photovoltaïques 6,7,8, adjacentes.

Pour que, dans ces deux bandes centrales 10, l'épaisseur du composite 1 ne soit pas une épaisseur réduite E₀, la couche de protection 15 et les première 13 et seconde couche 14 de liaison s'étendent transversalement au-delà des cellules photovoltaïques dans ces deux bandes centrales. Ainsi l'écart d'épaisseur dans toute la largeur du panneau photovoltaïque 4 n'est que de l'épaisseur de la cellule photovoltaïque proprement dite, c'est-à-dire de l'ordre de 50 µm, ce qui est relativement négligeable, quand on compare cet écart à l'épaisseur totale des deux couches de liaison et de la couche de protection qui peut faire de l'ordre de 500 à 600 µm. Grâce à cette disposition particulière, les deux bandes centrales 10 ne sont pas des zones d'épaisseur réduite et le panneau photovoltaïque 4 a une épaisseur sensiblement constante sur toute sa largeur et bien sûr sur toute sa longueur selon la partie arrière 9. Bien sur, lorsque cela s'avère possible, les cellules photovoltaïques peuvent être rapprochées au plus près l'une de l'autre pour limiter la largeur voire supprimer lesdites bandes centrales.

S'agissant de la bande latérale gauche 11, une première voie pour réduire la largeur de cette bande est d'augmenter latéralement les dimensions des couches de liaison et de protection par rapport à la cellule photovoltaïque. Sur la figure 2, la première couche de liaison 13, la seconde couche de liaison 14 et la couche de protection 15 ont toutes les mêmes dimensions, se prolongeant sur une distance g, au-delà de la cellule photovoltaïque 16. Une seconde voie réside dans la finition du bord longitudinal gauche du panneau textile. Traditionnellement, dans le domaine des stores, la finition consiste à former un ourlet avec repli partiel et couture. Dans la zone de cet ourlet, le composite 1 a une épaisseur E₁ qui est double de celle E₀ du panneau textile 2, ce qui correspond sensiblement à l'épaisseur E₂ du composite dans la zone du panneau photovoltaïque 4, incluant la cellule 6.

S'agissant de la bande latérale 12 droite, elle comprend la zone d'assemblage 19 entre les deux panneaux textiles 2,3. Comme illustré sur la figure 2, l'assemblage est réalisé par superposition et collage des deux lisières superposées 2a,3a des deux panneaux 2,3. Dans cette zone d'assemblage 19, le composite 1 a une épaisseur E₁ qui est sensiblement le double de l'épaisseur E₀ du panneau textile, si l'on intègre la présence de colle mais aussi la réduction d'épaisseur des deux plis de panneau textile due à l'écrasement lors du laminage à chaud. Cette zone d'assemblage a donc sensiblement la même épaisseur E₂ que l'épaisseur E₂ du composite dans la partie arrière 9. Ainsi, dans cet exemple de réalisation, la bande latérale droite 12 qui forme une zone à épaisseur réduite s'étend entre le bord gauche 3b du second panneau textile 3 et le bord droit 4b du panneau photovoltaïque 4 disposé sur le premier panneau textile 2.

Il est donc également possible de régler la largeur d de cette zone en ajustant la largeur de la zone d'assemblage 19.

On comprend que le schéma simplifié de la figure 2 ne représente pas strictement la configuration du composite, notamment lorsqu'il est enroulé sur un tube de réception, du fait de la déformation naturelle du panneau textile, en particulier dans les zones d'épaisseur réduite.

Dans le mode de réalisation illustré à la figure 1, la partie avant 18 du composite 1 est exempte de panneau photovoltaïque 4, de sorte que dans cette partie avant 18, l'épaisseur du composite est strictement celle du panneau textile 2.

Dans sa mise en oeuvre comme store de protection solaire, le composite 1 a son bord transversal la qui est fixé sur un tube de réception 20 pour son enroulement tandis que le bord transversal opposé 1b du composite est fixé sur une barre de charge 21.

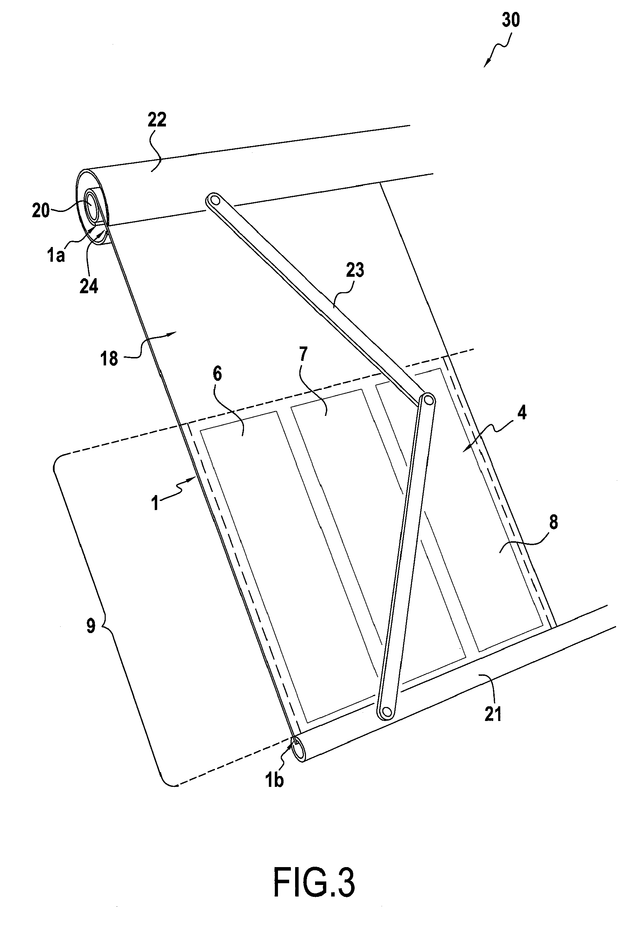

Dans l'exemple illustré à la figure 3, le tube de réception 20 est monté rotatif dans un corps de rangement 22 intérieurement cylindrique. La barre de charge 21 et le coffre de rangement 22 sont reliés par un ou plusieurs bras 23 de mise en tension. Il s'agit d'un bras articulé ou éventuellement télescopique, apte à tenir écartés l'un de l'autre la barre de charge 21 et le coffre 22 et par conséquent mettre en tension le composite 1 lorsqu'il est en position déployée et également lors de son enroulement autour du tube de réception 20.

Le dispositif de protection solaire 30 comporte également des moyens d'acheminement, non représentés sur la figure 3, de l'énergie électrique produite par les cellules photovoltaïques. Il convient en effet d'acheminer vers un moyen de stockage tel qu'une batterie ou directement au réseau l'énergie électrique produite par les cellules photovoltaïques. Quel que soit le montage électrique adopté, qu'il soit en série ou en parallèle, les moyens d'acheminement partent des électrodes des cellules et passent par l'intérieur de la barre de charge 21, par l'intérieur d'un ou plusieurs bras 23 et par l'intérieur du coffre de rangement 22 ou du tube de réception 20 pour être dirigés vers les moyens de stockage ou le réseau.

Lorsque le composite 1 est totalement enroulé autour du tube de réception 20, la barre de charge 21 vient occulter la fente 24 du coffre de rangement par laquelle passe le composite 1.

On cherche de manière générale à limiter l'encombrement de tels dispositifs. Pour cela, on cherche à réduire le diamètre extérieur du coffre de rangement 22, ce qui conduit à réduire également ledit diamètre du tube de réception 20. Toutefois une limitation à cette réduction apparaît du fait que les cellules photovoltaïques, même si elles sont souples, ne peuvent être recourbées selon un rayon de courbure trop faible sous peine de cassures, entrainant un dysfonctionnement rédhibitoire. Actuellement, les rayons de courbure admissibles pour les cellules photovoltaïques commercialisées sont de l'ordre de 3 centimètres.

La disposition particulière du composite 1 selon la présente invention, illustré à la figure 1, selon laquelle la partie avant 18 est exempte de panneau photovoltaïque permet néanmoins de diminuer le rayon du tube d'enroulement 20 à une valeur inférieure à celui du rayon de courbure admissible pour une cellule photovoltaïque. En effet, lors de l'enroulement, les premières spires du composite 1 sont exclusivement dans le panneau textile 2 qui, lui, peut être enroulé sur un tube de diamètre très faible. Lorsqu'intervient l'enroulement de la partie arrière 9, comprenant le panneau photovoltaïque 4, le diamètre effectif de l'enroulement correspond à celui du tube 20 augmenté des spires formées par l'enroulement de la partie avant 18. C'est donc ce dernier diamètre qui est à prendre en considération au regard du rayon de courbure admissible pour une cellule photovoltaïque.

Dans l'exemple illustré, la partie avant 18 représente sensiblement le tiers de la longueur du composite 1. Un avantage significatif de réduction de diamètre du tube de réception 20 est néanmoins obtenu à partir d'une partie avant ayant une longueur La qui fait au moins le quart de la longueur totale Lt du composite.

Dans un exemple précis de réalisation d'un store pour camping-car, la longueur totale Lt du composite 1 était de 2542 millimètres et la longueur La de la partie avant 18 était de 1097 millimètres, soit 43 % de Lt. Il est à noter que la partie avant 18 ainsi que l'extrémité de la partie arrière, exempte toutes deux de panneau photovoltaïque, sont utilisées pour la fixation sur respectivement le tube de réception 20 et sur la barre de charge 21. Plus précisément, dans cet exemple précis, la partie visible de la partie avant est de l'ordre de 900 millimètres et la partie visible de la partie arrière 9, correspondant au panneau photovoltaïque 4, est de l'ordre de 1400 millimètres.

Dans un premier temps, ce composite a pu être mis en oeuvre dans un matériel standard utilisé par les storistes avec un tube de réception 20 ayant un diamètre extérieur de 63 millimètres et un coffre de rangement 22 ayant un diamètre intérieur de 87 millimètres. Comme indiqué précédemment, il sera, grâce à la particularité de l'invention, possible de diminuer très sensiblement l'encombrement du coffre de rangement par une diminution significative du diamètre du tube de réception jusqu'à des valeurs égales ou inférieures à 50 millimètres, voire inférieures à 40 millimètres.

Dans ce même exemple précis de réalisation, les zones 11,12 dites d'épaisseur réduite avaient une épaisseur E₀ faisant de l'ordre de 0,6 millimètres correspondant à l'épaisseur uniquement du panneau textile. L'ourlet 17 et la zone d'assemblage 19 avaient une épaisseur E₁ de l'ordre de 1,2 millimètres, correspondant au double de celle du panneau textile. Le panneau photovoltaïque 4 à l'aplomb des cellules photovoltaïques 6 avait une épaisseur E₂ de l'ordre de 1,3 millimètres.

## Revendications

1. Composite (1) enroulable photovoltaïque, notamment pour la protection solaire, comprenant au moins un panneau photovoltaïque souple (4) et au moins un panneau textile (2) sur la face extérieure (2a) duquel est laminé ledit panneau photovoltaïque à l'aide d'une première couche de liaison (13) **caractérisé en ce que**, dans la direction transversale (F) à celle prévue pour son enroulement et à tout niveau (9) du panneau photovoltaïque (4), il présente une épaisseur (E) sensiblement constante, ne comportant qu'une ou plusieurs zones (11,12) d'épaisseur réduite (E₀), ladite épaisseur correspondant à l'épaisseur du panneau textile (2) éventuellement revêtu d'une enduction sur sa face intérieure, dont la largeur ℓ est au plus de 8 centimètres, en sorte d'éviter la formation de plis lors de l'enroulement ou en position déployée.

2. Composite selon la revendication 1, **caractérisé en ce que** le panneau photovoltaïque (4) comprend au moins une cellule photovoltaïque (6,7,8) recouverte par une couche de protection (15), dans un matériau laissant passer le rayonnement lumineux, par exemple en ETFE, laquelle couche de protection étant laminée sur la cellule (6,7,8) à l'aide d'une seconde couche de liaison (14), et **en ce que** la première et la seconde couches de liaison et la couche de protection ont les mêmes dimensions, lesquelles sont supérieures à celles de la cellule photovoltaïque.

3. Composite selon l'une des revendications 1 ou 2, **caractérisé en ce que** ses bords longitudinaux ont une épaisseur sensiblement double de celle du panneau textile, celui-ci ayant été replié pour former un ourlet de finition (17).

4. Composite selon l'une des revendications 1 à 3, **caractérisé en ce qu'**il comporte au moins deux panneaux textiles (2,3) assemblés deux à deux par superposition et assemblage d'une portion (2a,3a) s'étendant le long de leurs bords longitudinaux adjacents, **en ce que** sur chaque panneau textile est laminé au moins une cellule photovoltaïque (6) et **en ce que** le bord longitudinal (3b) du panneau textile (3) venant au-dessus de l'autre panneau textile (2) dans l'assemblage est à une distance d du panneau photovoltaïque (6) de cet autre panneau textile (2), d étant au plus égal à 8 centimètres.

5. Composite selon l'une des revendications 1 à 4, **caractérisé en ce que** la largeur ℓ et éventuellement la distance d sont au plus égales à 4 centimètres, notamment inférieures à 2 centimètres et de préférence proches de zéro.

6. Composite selon l'une des revendications 4 ou 5, **caractérisé en ce que** les faces intérieures (2c,3c) des panneaux textiles (2,3) assemblés sont revêtues d'une enduction anti-transpercement, exception faite de la portion (3a), dite de réserve, du panneau textile (3) venant au-dessus de l'autre (2) dans l'assemblage.

7. Composite selon l'une des revendications 1 à 6, **caractérisé en ce qu'**il comporte une partie avant (18), dont le bord transversal (1a) est destiné à être fixé à un tube de réception (20) pour son enroulement, qui est exempte de panneau photovoltaïque.

8. Composite selon la revendication 7, **caractérisé en ce que** la partie avant (18) du composite (1) a une longueur La qui fait au moins le quart de la longueur totale Lt dudit composite.

9. Dispositif de protection solaire (30) comportant un tube de réception (20), une barre de charge (21), un composite (1) selon l'une des revendications 1 à 8, dont le bord transversal avant (1a) est fixé au tube de réception et le bord transversal arrière (1b) est fixé à la barre de charge (21), au moins un bras (23) relié au tube de réception et à la barre de charge et assurant la mise sous tension du composite en position déployée et des moyens d'acheminement de l'énergie électrique produite par la ou les cellules photovoltaïques.

10. Dispositif selon la revendication 9, comportant un composite selon l'une des revendications 7 ou 8, **caractérisé en ce que** le tube de réception a un rayon extérieur qui est inférieur à 2,5 centimètres.

11. Dispositif selon la revendication 10, comportant un composite selon la revendication 8, **caractérisé en ce que** le tube de réception a un rayon extérieur qui est inférieur à 2 centimètres.
